Europäisches Patentamt

European Patent Office

Office européen des brevets

(11) Numéro de publication: **0 0 1 5 8 2 1**
A1

# (12) DEMANDE DE BREVET EUROPEEN

(21) Numéro de dépôt: 80400265.7

(22) Date de dépôt: 26.02.80

(51) Int. Cl.³: **H 01 L 29/06, H 01 L 21/225**

(30) Priorité: 02.03.79 FR 7905502

(43) Date de publication de la demande: 17.09.80
Bulletin 80/19

(84) Etats contractants désignés: **DE GB IT**

(71) Demandeur: **"THOMSON-CSF"- SCPI, 173, Boulevard
Haussmann, F-75360 Paris Cedex 08 (FR)**

(72) Inventeur: **Peyre Lavigne, André, "THOMSON-CSF" -
SCPI 173, Bld Haussmann, F-75360 Paris Cedex 08 (FR)**
Inventeur: **Collumeau, Annie, "THOMSON-CSF" -
SCPI 173, Bld Haussmann, F-75360 Paris Cedex 08 (FR)**

(74) Mandataire: **Giraud, Pierre et al, "THOMSON-CSF" -
SCPI 173, bld Haussmann, F-75360 Paris Cedex 08 (FR)**

(54) **Dispositif semiconducteur, muni d'un anneau de garde et son procédé de fabrication.**

(57) L'invention concerne les dispositifs semiconducteurs
comportant un anneau de garde.

Les procédés de réalisation classiques des anneaux
de garde, par diffusion localisée à travers des fenêtres
dans un masque épais, entraînent une polution superficielle du cristal et des perturbations cristallines. Le procédé
selon l'invention consiste à déposer d'abord sur le cristal
une source de diffusion (44), limitée à l'emplacement du
futur anneau de garde (43), puis à effectuer la diffusion.
Les jonctions ainsi réalisées sont fiables et exemptes de
bruit.

Application aux diodes et transistors.

EP 0 015 821 A1

# DISPOSITIF SEMICONDUCTEUR, MUNI D'UN ANNEAU DE GARDE ET SON PROCEDE DE FABRICATION

La présente invention concerne les dispositifs semiconducteurs et se rapporte en particulier à la réalisation des anneaux de garde des jonctions d'un tel dispositif. Elle s'applique par exemple mais de façon non limitative aux diodes fonctionnant en régime d'avalanche, la description donnée ci-après se situant notamment dans le cas d'une jonction d'une telle diode ; toutefois, l'invention est aussi bien applicable dans le cas des dispositifs comportant plusieurs jonctions, tels que les transistors.

Le fonctionnement normal d'une diode à avalanche exige que celle-ci ait lieu en volume lorsque la tension d'avalanche est atteinte. En fait, dans les diodes telles qu'elles sont réalisées selon l'art connu, le claquage se produit préférentiellement en surface plutôt qu'en volume, en raison d'une part du champ électrique plus élevé en surface qu'en profondeur, et d'autre part de la présence d'impuretés en surface du cristal semiconducteur, impuretés provenant des étapes de fabrication.

La présente invention, en proposant une structure originale pour les jonctions des dispositifs semiconducteurs améliore leur tenue en tension grâce notamment à la présence, au cours d'une étape de diffusion, d'une couche de silice qui s'oppose à la pollution de la surface du cristal semiconducteur.

De façon plus précise, l'invention concerne un dispositif semiconducteur comportant une première région d'un premier type de conductivité formant avec le substrat d'un second type de conductivité une jonction dont la charge d'espace est limitée par un anneau de garde diffusé qui entoure la jonction, caractérisé en ce que l'anneau de garde comporte en premier lieu une région diffusée, en second lieu une source de diffusion déposée sur la surface de la région diffusée extérieure au substrat et en troisième lieu une couche isolante qui remplit la double fonction de masque pour la source de diffusion et de barrage contre l'exodiffusion des impuretés dopantes.

L'invention sera mieux comprise à l'aide de la description qui suit, laquelle s'appuie sur les figures qui représentent :

- figure 1 : une jonction selon l'art connu, sans anneau de garde ;

- figure 2 : une jonction selon l'art connu, avec anneau de garde ;

- figure 3 : les courbes de caractéristiques électriques des deux jonctions précédentes, rapprochées de la courbe de caractéristiques selon l'invention ;

- figure 4 : une jonction selon l'invention ;

- figures 5a à 5f : le procédé de fabrication des diodes selon l'invention.

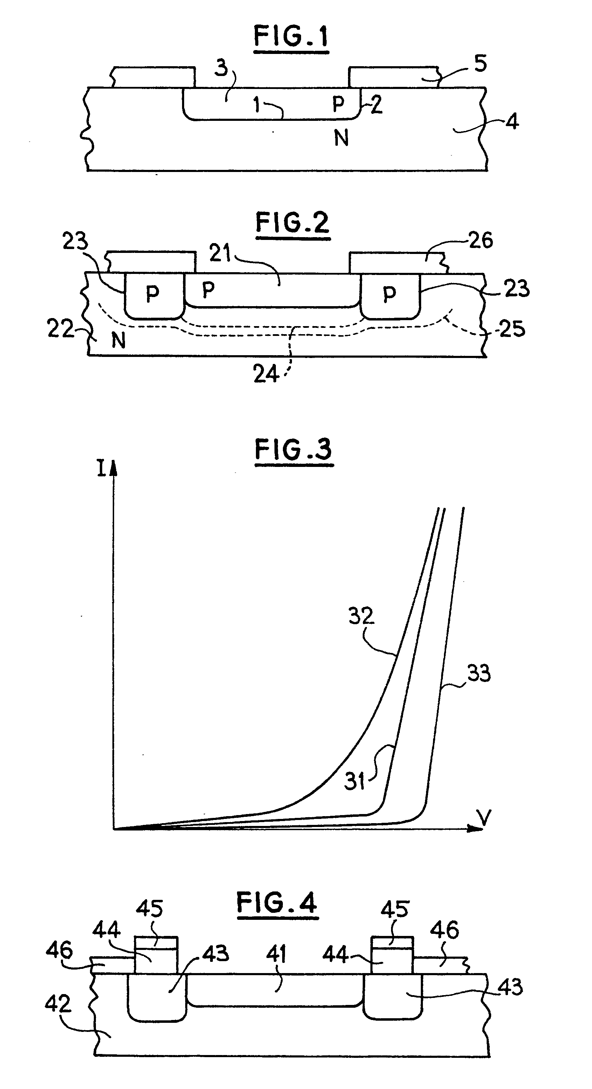

La figure 1 représente une jonction classique, sans anneau de garde, selon l'art connu.

Pour l'homme de l'art, une telle jonction est dite planaire, parce qu'elle est composée d'une jonction plane 1 et d'une jonction cylindrique 2 qui séparent deux zones dans un cristal semiconducteur, une première zone 3 d'un type de conductivité (P par exemple) et une deuxième zone 4 d'un type de conductivité opposée (N par exemple). Pour une jonction planaire, la tension de claquage est inférieure à celle d'une jonction plane, pour des taux de dopage identiques des matériaux semiconducteurs, parce que le champ électrique est plus élevé en 2 qu'en 1.

De plus, la surface du cristal semiconducteur comporte toujours des impuretés qui sont demeurées après les traitements de nettoyage d'oxydation et de masquage préalables à la diffusion localisée de la jonction.

Enfin, une jonction classique comporte très généralement une couche superficielle isolante 5, qui se trouve être de la silice $SiO_2$ si le cristal est du silicium. Selon les processus de fabrication classiques, cette couche est épaisse d'environ 8000 angströms : ceci constitue un inconvénient car le silicium et la silice n'ayant pas les mêmes constantes thermiques, notamment en regard de la dilatation, la couche isolante 5 introduit des perturbations cristallines consécutives aux opérations thermiques, perturbations essentiellement localisées dans la zone de jonction cylindrique proche de la surface du cristal.

Ainsi, en régime de polarisation inverse, du fait du champ électrique plus élevé à proximité de la surface, de la présence d'impuretés en surface et de perturbations dans le réseau cristallin proche de la surface, le claquage se produit préférentiellement en surface et non en volume. Un tel fonctionnement est préjudiciable au dispositif puisque tout le courant s'écoule à travers une partie restreinte de la jonction au lieu d'en utiliser toute la surface.

La définition du phénomène de claquage sera utile pour une meilleure compréhension de la suite du texte. Dans une jonction P/N à l'équilibre, il y a dans la couche de conductivité P une certaine fraction d'électrons libres équilibrés par autant de "trous" - c'est-à-dire de déficit en électrons - dans la couche de conductivité N. Lorsque le champ électrique entre les deux couches atteint la tension d'avalanche il ionise le sicilium métallique entre les deux couches et arrache des électrons aux atomes de silicium. La courbe de caractéristique tension/intensité de la jonction présente un coude et "entre en avalanche" : c'est le "claquage". Lorsque la tension diminue, et après claquage, la jonction redevient normale.

La figure 2 représente une jonction comparable à celle de la figure 1 : cependant, la jonction planaire est entourée par un anneau de garde qui constitue une solution parmi d'autres pour pallier à l'inconvénient du claquage en surface.

Pour simplifier la comparaison, la jonction prise en exemple figure 2 est de même nature que celle de la figure 1 : région 21 dopée P dans un substrat 22 dopé N, et protégée par une couche 26.

Un anneau de garde 23, de même type de conductivité P que la zone diffusée 21 de la jonction, entoure la jonction cylindrique et peut soit en être séparé par une zone de substrat soit lui être concommittante.

D'une manière générale, l'anneau de garde, par sa position par rapport à la jonction, a pour fonction de modifier l'espace occupé par la charge d'espace qui se développe quand la jonction est polarisée en inverse.

La charge d'espace s'étend en majeure partie du côté le moins dopé de la jonction (substrat N22 dans le cas de l'exemple), sur une épaisseur proportionnelle à la racine carrée de la tension appliquée.

L'anneau de garde est positionné de manière telle que la charge d'espace de la jonction vienne buter sur lui pour une tension inférieure à la tension d'avalanche, comme indiqué par la ligne 24 de la figure 2, qui symbolise une équipotentielle de charge d'espace. Pour un accroissement de la tension, égale ou supérieure à la tension d'avalanche, la charge d'espace s'étend au-delà de l'anneau de garde, comme indiqué par la ligne d'équipotentielle 25. Une telle structure minimise les effets néfastes de surface de la jonction et permet un fonctionnement en avalanche qui en utilise toute la surface.

Ainsi, la présence d'un anneau de garde améliore la fiabilité des diodes fonctionnant en avalanche. Toutefois, le mode de réalisation de cet anneau par diffusion localisée classique, tend à augmenter le courant de fuite de la jonction ainsi que le bruit.

Dans une diffusion localisée classique, les impuretés dopantes sont diffusées dans le substrat à travers une fenêtre ouverte dans la couche d'oxyde isolante précédemment formée en surface du substrat. Afin que les impuretés dopantes ne traversent pas la couche d'oxyde, celle-ci doit avoir une épaisseur d'au moins 8000 angströms, formés par oxydation thermique du silicium du substrat ; en effet, la silice thermique est plus imperméable aux impuretés dopantes que la silice pyrolitique déposée par décomposition à chaud d'un composé du silicium. Mais la présence de 8000 angströms de silice introduit une perturbation cristalline sur 3 microns d'épaisseur c'est-à-dire 30.000 angströms) dans le silicium, perturbation inacceptable eu égard aux 5 microns d'épaisseur de l'anneau de garde.

Au cours de ces opérations de réalisation de l'anneau de garde, la présence d'impuretés en surface du cristal semiconducteur augmente le courant de fuite de la jonction, notamment dans la région voisine de la jonction cylindrique. Les perturbations cristallines, irrémédiables, apportées par les traitements thermiques, augmentent le bruit par génération d'une densité de défauts élevée dans le silicium.

La figure 3 illustre le fonctionnement d'une jonction sans anneau de garde et avec anneau de garde.

L'intensité I étant portée en ordonnées et la tension V en abscisses, la courbe 31, qui correspond à une jonction sans anneau de garde, montre que le courant de fuite I varie peu tant que la tension n'a pas atteint le coude de la tension d'avalanche. A partir de cette valeur de tension, l'intensité croît brusquement. Une jonction sans anneau de garde est donc peu bruiteuse - c'est-à-dire qu'elle présente peu de bruit ou de dérive aux abords de la tension d'avalanche - mais elle est également peu fiable puisque, comme il a été dit, le claquage a lieu en surface plutôt qu'en volume.

La courbe 32 représente la caractéristique courant-tension d'une jonction munie d'un anneau de garde : elle est fiable, puisque l'anneau de garde s'oppose au claquage en surface, mais bruiteuse : le bruit correspond à la région située entre la courbe 32 et l'axe des tensions, et il varie comme le carré de l'intensité. Le coude de tension d'avalanche n'est pas net.

La courbe 33 représente la caractéristique courant-tension d'une jonction selon l'invention : elle est peu bruiteuse parce que son procédé de fabrication n'amène pas de perturbations dans le réseau cristallin, et elle est en outre fiable parce qu'elle comporte un anneau de garde et que sa tension d'avalanche est nettement caractérisée.

La figure 4 représente une jonction selon l'invention.

Cette jonction comporte une région 41, d'un premier type de conductivité, et un substrat 42, d'un second type de conductivité. La jonction entre régions 41 et 42 est entourée par un anneau de garde 43, qui est représenté adjacent à la région 41 sur la figure 4, mais peut en être séparé sans que cela sorte du cadre de l'invention.

Une caractéristique de l'invention est que l'anneau de garde 43 est surmonté par une couche 44 qui constitue une source de diffusion, elle-même recouverte d'une couche isolante 45.

La surface du cristal semiconducteur 42, extérieure à la jonction et notamment à la source de diffusion 44, est recouverte d'une couche isolante 46, dont une caractéristique est de n'être épaisse que de 800 angströms environ, c'est-à-dire approximativement le dixième de l'épaisseur de la couche isolante réalisée selon les procédés connus.

L'épaisseur de cette couche isolante 46 a une fonction importante dans les caractéristiques de la jonction. Elle est faible parce que la diffusion de l'anneau de garde s'effectue à partir de la source de diffusion 44, et que, dans ces conditions, il n'est plus indispensable de lui donner une épaisseur de 8000 angströms telle qu'elle fasse barrière à la diffusion des impuretés dopantes. Puisque son épaisseur est dix fois moindre que selon les procédés de l'art antérieur, les différences de coefficient de dilatation jouent moins au cours des opérations thermiques, et il n'y a plus de perturbations cristallines en surface des régions 41, 42 et 43.

Les détails de réalisation d'une jonction selon l'invention permettront de mieux comprendre les avantages d'une telle jonction.

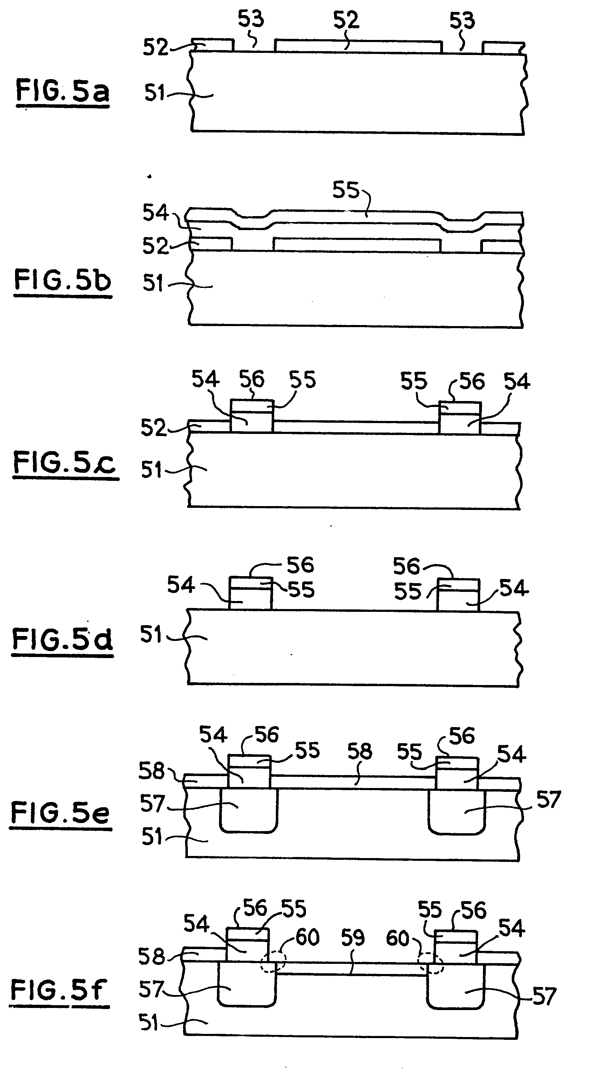

Les figures 5 représentent les différentes étapes du processus de réalisation.

Sur un substrat 51, d'un premier type de conductivité, est déposée une couche isolante de silice pure 52, sur une épaisseur de 800 angströms environ, selon un procédé thermique. Par des procédés de masquage bien connus de l'homme de l'art, une ouverture 53 est pratiquée dans la couche 52, cette ouverture ayant la forme et les dimensions superficielles du futur anneau de garde.

La figure 5b montre qu'une source de diffusion 54 est déposée, préférentiellement par voie chimique en phase vapeur, dans les ouvertures 53. Etant donné le procédé de dépôt, cette source de diffusion se trouve également déposée sur la couche isolante 52. A titre indicatif, et pour prendre en exemple le cas du silicium dopé au bore, cette couche peut être formée par la réaction du silane $SiH_4$ avec le bromure de bore $BBr_3$, dilué dans l'azote à 620° C, sous vide partiel.

La couche 54 peut être formée soit de silice, soit de silicium polycristallin : elle est dopée au bore, à l'aluminium ou au gallium si la jonction est du type PN, ou dopée au phosphore ou à l'arsenic si la jonction est du type NP, ces corps constituant les impuretés dopantes.

La couche 54 est ensuite recouverte par une couche de silice pure 55, obtenue par réaction pyrolytique, et qui a une épaisseur de 5000 angströms. Le rôle de cette couche 55 est d'éviter l'exodiffusion des produits dopants au cours des opérations ultérieures.

L'ensemble est soumis à un traitement de photogravure de façon à ne laisser subsister que des îlots, situés au-dessus des ouvertures 53, dans les couches 54 et 55 : c'est ce que montre la figure 5c. L'ensemble d'un îlot 54 et de son "couvercle" 55 constitue une source de diffusion 56.

L'attaque du silicium polycristallin de la couche 54 est de préférence effectuée par gravure par plasma, après avoir protégé les emplacements des sources 56 par un masquage photographique adéquat. Le plasma attaque les couches de silice pyrolytique 55 et de silicium polycristallin 54 - en dehors des zones protégées -mais n'attaque pas la silice thermique de la couche 52.

L'attaque est terminée - figure 5d - par une gravure en phase liquide, au moyen de fluorures ou d'acide fluorhydrique, qui dissolvent la couche de silice thermique 52 : une nouvelle couche de silice qui sera formée ultérieurement sera, quant à elle, exempte d'impuretés incluses.

La couche "couvercle" 55 avait à l'origine une épaisseur de 5000 angströms, tandis que la couche de silice thermique 52 n'avait que 800 angströms d'épaisseur. La finesse relative de la couche 52 permet une meilleure définition des ouvertures et n'apporte pas de contraintes mécaniques. Par contre, l'épaisseur relative de la couche 55 fait que, lorsque la couche 52 est complètement dissoute par les fluorures, il reste encore de la couche 55 une épaisseur suffisante pour servir de couvercle et s'opposer à l'exodiffusiondes impuretés dopantes au cours de l'étape ultérieure.

Les plaquettes sont alors soumises à un traitement thermique de diffusion en atmosphère oxydante, soit oxygène seul, soit oxygène et acide chlorhydrique (figure 5e). Les impuretés dopantes (bore, ou phosphore ...) migrent de la source de diffusion 54 dans laquelle elles ont été précédemment "stockées", d'après le processus de fabrication de cette source, et elles pénètrent dans le substrat 51 pour y former l'anneau de garde 57, à une profondeur réglée en ajustant le temps et la température de diffusion.

Au cours de ce traitement, une couche de silice 58 se forme en surface du silicium laissé à nu.

Après élimination par une solution de fluorures de la région de silice 58 qui se trouve à l'intérieur de l'anneau de garde 57 (figure 5f), la jonction 59 est enfin formée par diffusion d'impuretés dopantes en four de diffusion selon un procédé classique ou celui décrit selon la présente invention, la conductivité de la jonction 59 étant du type opposé à celle du substrat 51.

Un perfectionnement au procédé consiste à effectuer un ultime nettoyage de la surface libre de la couche 59, par plasma par exemple.

Par rapport aux procédés de réalisations classiques, ce procédé nouveau évite les défauts inhérents à l'oxydation en surface et aux perturbations cristallines, en particulier dans les régions 60 mixtes à la jonction et à

8

l'anneau de garde, défauts qui sont à l'origine du bruit et des courants de fuite élevés.

L'invention a été décrite en s'appuyant sur une seule jonction, assimilable à une diode, mais elle concerne tous dispositifs comprenant une pluralité de jonctions, tels que les transistors et les thyristors ou triacs.

REVENDICATIONS

1.Dispositif semiconducteur, muni d'un anneau de garde, comportant une première région (59) d'un premier type de conductivité, formant avec le substrat (51) d'un second type de conductivité une jonction, cet anneau de garde étant caractérisé, en premier lieu, en ce qu'il constitue avec le substrat une jonction dont la tension d'avalanche est supérieure à celle de la jonction qu'il entoure et, en second lieu, en ce qu'il comporte une région diffusée (57) sur laquelle sont déposées une première couche (54), source de diffusion des impuretés dopantes vers l'anneau de garde, et une seconde couche (55) qui remplit la double fonction de masque pour la source de diffusion (54) et de barrage contre l'exodiffusion des impuretés dopantes, les première et seconde couches constituant de plus par rapport à la surface du semiconducteur, un relief qui a la même géométrie que l'anneau de garde.

2. Dispositif semiconducteur selon la revendication 1, caractérisé en ce que la source de diffusion (54) est en silicium polycristallin dopé par des impuretés correspondant au type de conductivité de la région diffusée (57).

3. Dispositif semiconducteur selon la revendication 1, caractérisé en ce que la source de diffusion (54) est en silice dopée par des impuretés correspondant au type de conductivité de la région diffusée (57).

4. Dispositif semiconducteur selon la revendication 1, caractérisé en ce que la couche isolante (55) est en silice.

5. Procédé de fabrication d'un dispositif semiconducteur, selon la revendication 1, caractérisé en ce qu'il comporte les étapes de réalisation suivantes :

- à partir d'un substrat (51) dépôt d'une première couche isolante (52) et photogravure de la fenêtre (53) de diffusion de l'anneau de garde ;

- dépôt d'une couche de diffusion (54) et d'une seconde couche isolante (55) ;

- masquage et attaque par les procédés connus des couches isolantes (52 et 55) et de la couche de diffusion (54) afin d'isoler l'îlot de source de diffusion (56) ;

- diffusion de la région (57) d'anneau de garde, accompagnée de la formation d'une nouvelle couche isolante (58) en surface du cristal ;

0015821

- photogravure et attaque de la couche isolante (58) à l'intérieur de l'anneau de garde, et diffusion de la région de jonction (59).

0015821

## FIG.1

## FIG.2

## FIG.3

## FIG.4

0015821

FIG.5a

FIG.5b

FIG.5c

FIG.5d

FIG.5e

FIG.5f

Office européen
des brevets

**RAPPORT DE RECHERCHE EUROPEENNE**

0015821

Numéro de la demande

EP 80 40 0265

| | DOCUMENTS CONSIDERES COMME PERTINENTS | | CLASSEMENT DE LA DEMANDE (Int. Cl. ³) |
|---|---|---|---|
| Catégorie | Citation du document avec indication, en cas de besoin, des parties pertinentes | Revendication concernée | |
| | FR - A - 2 230 081 (SONY)<br><br>* Revendications 1,5,6,13; figure 4 *<br><br>-- | 1,2,4 | H 01 L 29/06<br>21/225 |
| | IBM TECHNICAL DISCLOSURE BULLETIN, vol. 21, no. 7, décembre 1978, New York US<br>N.G. ANANTHA et al.: "Schottky Barrier Diode with Polycrystalline Silicon Guard Ring", page 2752<br><br>* Page 2752, paragraphe 2; figures *<br><br>-- | 1,2,4, 5 | |
| | IBM TECHNICAL DISCLOSURE BULLETIN, vol. 21, no. 2, juillet 1978 New York US<br>G.M. OLESZEK et al.:"Phase Layer Boron Diffusion Process for Second Breakdown Free Power Switching Transistors", pages 675-676.<br><br>* Figures 3a-3f *<br><br>-- | 1,2,4, 5 | |
| A | IEEE JOURNAL OF SOLID STATE CIRCUITS, vol. SC-12, no. 2, avril 1977 New York US<br>J. MIDDELHOEK et al.: "Polycrystalline Silicon as a Diffusion Source and Interconnect Layer in $I^2L$ Realizations", pages 135-138<br><br>* Figure 4 *<br><br>-- | 5 | |
| A | DE - A - 1 614 691 (SIEMENS)<br><br>* Revendications 1,4 *<br><br>& FR - A - 2 347 253<br><br>---- | 3,4 | |

**DOMAINES TECHNIQUES RECHERCHES (Int. Cl. ³)**

H 01 L 29/06
21/225

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achevement de la recherche | Examinateur |
|---|---|---|
| La Haye | 10-06-1980 | VANCRAEYNEST |

OEB Form 1503.1   06.78